# EUROPÄISCHE PATENTSCHRIFT

(11) **EP 4 239 884 B1**
(45) Veröffentlichungstag und Bekanntmachung des Hinweises auf die Patenterteilung: **06.11.2024**
(21) Anmeldenummer: 23159464.9
(22) Anmeldetag: 01.03.2023
(51) Int. Cl.: H03K 3/537, H02M 7/217, G01R 33/38

(54) **MARX-GENERATOR MIT MEHREREN ZWEIGEN FÜR JEWEILIGE MARX-SPANNUNGEN**
MARX GENERATOR HAVING A PLURALITY OF BRANCHES FOR RESPECTIVE MARX VOLTAGES
GÉNÉRATEUR DE MARX À BRANCHES MULTIPLES POUR TENSIONS MARX RESPECTIVES

(30) Priorität: 04.03.2022 DE 102022000764
(43) Veröffentlichungstag der Anmeldung: 06.09.2023
(73) Patentinhaber: Diehl Defence GmbH & Co. KG, 88662 ÜBERLINGEN (DE)
(72) Erfinder: Urban, Jürgen, 91056 Erlangen (DE); Sporer, Michael, 91207 Lauf (DE)
(74) Vertreter: Diehl Patentabteilung

(56) Entgegenhaltungen:
- US-A1- 2012 193 992
- US-A1- 2018 367 125

## Beschreibung

Die Erfindung betrifft einen Marx-Generators sowie von diesem mit Marx-Spannung versorgte Resonatoren.

US 2018/367125 A1 offenbart eine Topologie mit mehreren parallel geschalteten Marx Generatoren, um gemeinsam einen Ausgangsimpuls zu erzeugen.

Aus der DE 10 2018 004 568 A1 ist eine Strahlungsquelle bekannt zur Abstrahlung eines elektromagnetischen HPEM-Mikrowellen-Pulses. Diese enthält einen Mikrowellen-Generator zur Erzeugung des Pulses, wobei der Generator eine Generatoröffnung zur Ausgabe des Pulses aufweist, und eine Hornstruktur zur Formung des Pulses, die eine mit der Generatoröffnung verbundene Eingangsöffnung zur Einstrahlung des Pulses und eine Abstrahlöffnung zur Abstrahlung des geformten Pulses aufweist, wobei der Generator mindestens zwei Pulsquellen zur jeweiligen Erzeugung eines Pulsanteils enthält, wobei der Puls die Summe der Pulsanteile ist. Eine Strahlungseinrichtung enthält eine erfindungsgemäße Strahlungsquelle und eine Steuereinrichtung zur zeitlich synchronisierten Auslösung der Pulsquellen zur jeweiligen Aussendung eines Pulsanteils.

Aus der Praxis ist es bekannt, eine solche Strahlungsquelle bzw. deren Pulsquellen in Form von Resonatoren mit Hilfe eines oder mehrerer zeitlich synchronisierter Marx-Generatoren mit Energie zu versorgen. Dabei wird die bzw. eine jeweilige Marx-Spannung an den Resonator angelegt.

Aufgabe der Erfindung ist es, eine verbesserte Lösung zur Speisung einer Strahlungsquelle mit einem Marx-Generator anzugeben.

Die Aufgabe wird gelöst durch einen Marx-Generator gemäß Patentanspruch 1.

Bevorzugte oder vorteilhafte Ausführungsformen der Erfindung sowie anderer Erfindungskategorien ergeben sich aus den weiteren Ansprüchen, der nachfolgenden Beschreibung sowie den beigefügten Figuren.

Der Marx-Generator enthält mindestens, insbesondere genau, zwei Zweige. Jeder der Zweige dient bzw. ist eingerichtet zur Abgabe einer jeweiligen Marx-Spannung an einem jeweiligen Ausgangspol (Potential-Ausgang) des Zweiges. Die Marxspannung stellt sich dabei vom Ausgangspol (insbesondere Hochspannungspotential) zu einem Gegenpol (insbesondere Masse oder negatives Hochspannungspotential) des Marx-Generators hin ein. Jeder Zweig weist also einen eigenen Ausgangspol auf. Im regulären bzw. bestimmungsgemäßen Betrieb des Marx-Generators wird also an jedem Zweig bzw. dessen Ausgangspol eine jeweilige Marxspannung bereitgestellt.

Jeder der Zweige enthält mehrere in Reihe geschaltete Kondensatorstufen. Jede der Kondensatorstufen weist mindestens einen ersten Spannungs-Pol und einen zweiten Spannungs-Pol auf. Jeder der Zweige enthält jeweilige Querzweige, wobei jeweils zwei benachbarte Kondensatorstufen eines Zweiges zwischen dem ersten Spannungs-Pol der vorhergehenden und dem zweiten Spannungs-Pol der nachfolgenden Kondensatorstufe durch einen der Querzweige verbunden sind. Jeder der Querzweige enthält eine Funkenstrecke. Jeder der Zweige enthält eine letzte Kondensatorstufe an seinem Ausgangsende. Einer der Spannungs-Pole bildet dabei den Ausgangspol des Zweiges. Jeder der Zweige enthält eine erste Kondensatorstufe an seinem Eingangsende, deren einer Spannungs-Pol mit einem Eingangspol zur Einspeisung einer Betriebsspannung verbunden. Auch die Betriebsspannung wird dabei zwischen dem Eingangspol und einem Gegenpol, der insbesondere zu dem der Ausgangspole identisch ist bzw. mit diesem leitend (im Sinne einer real ausgeführten theoretisch ideal leitenden Verbindung) verbunden ist.

Im Marx-Generator weisen mindestens, insbesondere genau, zwei der Zweige einen gemeinsamen Zündabschnitt auf. Der Zündabschnitt ist also ein gemeinsamer Teil beider Zweige, der jedoch nur einmal vorhanden ist. Im Zündabschnitt fallen die mindestens zwei der Zweige zusammen. Dies gilt mindestens hinsichtlich der ersten Kondensatorstufe und eines ersten Querzweiges, der zur betreffenden Kondensatorstufe benachbart ist, sowie den Eingangspol. Die in Rede stehenden mindestens zwei Zweige weisen also einen einzigen gemeinsamen Eingang / Eingangsende / Eingangspol auf, der jedoch Eingang für jeden einzelnen der betreffenden Zweige ist. Ebenso weisen sie eine einzige erste Kondensatorstufe und einen einzigen Querzweig gemeinsam auf; diese Komponenten sind also gleichsam Bestandteil beider Zweige.

Jeder der Zweige, die einen Zündabschnitt aufweisen, weist dann auch einen Einzelabschnitt auf. Der Einzelabschnitt stellt neben dem Zündabschnitt den "Rest" des betreffenden Zweiges dar. Der Einzelabschnitt enthält mindestens eine, nur dem Einzelabschnitt bzw. diesem Zweig zugeordnete Kondensatorstufe, optional auch mindestens einen entsprechenden Querzweig.

Mit anderen Worten setzen sich Zweige, die einen Zündabschnitt aufweisen, aus genau zwei Teilabschnitten zusammen, nämlich dem Zündabschnitt und dem Einzelabschnitt.

Bezüglich seines Grundprinzips, das heißt unter isolierter Betrachtung eines jeweiligen einzigen Zweiges ist der Marx-Generator an sich in fachüblicher Weise aufgebaut und enthält diesbezüglich mehrere Kondensatorstufen, die - im Sinne eines Marx-Generators - in Reihe geschaltet sind. Insofern sind die Kondensatorstufen durchnummerierbar als z. B. Kondensatorstufe 1 (erste), 2, ..., N (letzte). Jede der N Kondensatorstufen weist jeweils mindestens einen ersten Spannungs-Pol und einen zweiten Spannungs-Pol auf. Im Betrieb des Marx-Generators liegt an den ersten Polen z. B. positives Hochspannungspotential +HV des Eingangspols an, an den zweiten Polen negatives Hochspannungspotential -HV des Gegenpols. Zwischen den beiden Polen liegt im Betrieb dann die Gesamtspannung der jeweiligen Kondensatorstufe an.

In ebenso fachüblicher Weise enthält der Zweig des Marx-Generators Querzweige. Jeweils zwei benachbarte Kondensatorstufen des Zweiges sind durch einen der Querzweige verbunden. Der Querzweig führt jeweils vom ersten Pol einer vorhergehenden zum zweiten Pol einer nachfolgenden Kondensatorstufe bzw. verbindet er diese beiden Pole (oder umgekehrt jeweils den zweiten Pol mit dem ersten Pol). "Nachfolgend" bezieht sich hierbei auf die entsprechende Abfolge der Kondensatorstufen in der Reihenschaltung, im obigen Beispiel also auf die Reihenfolge 1, 2, ..., N.

In fachüblicher Weise sind im Marx-Generator alle ersten Spannungs-Pole über Ladeimpedanzen einer ersten Ladeleitung in Reihe geschaltet. Ebenso sind alle zweiten Spannungs-Pole über Ladeimpedanzen einer zweiten Ladeleitung in Reihe geschaltet. Auf diese Weise wird der Marx-Generator zwischen den jeweils gleichen Potentialen aufgeladen. Die Querzweige stellen dabei Leerläufe dar. Insofern sind die Kondensatorstufen im Ladezustand des Marx-Generators parallel geschaltet.

Die oben genannte "Reihenschaltung" der Kondensatorstufen bezieht sich im Gegensatz hierzu jedoch auf den - diesbezüglich als wesentlich betrachteten - Entladevorgang durch die leitenden bzw. kurzgeschlossenen Querzweige. Die Ladeimpedanzen wirken dabei wie ein jeweiliger Leerlauf.

Um den entsprechenden Leerlauf beim Lade- und den Kurzschluss beim Entladevorgang und damit die Reihenschaltung herzustellen, enthält jeder der Querzweige eine Funkenstrecke, die bei ihrem Durchbruch kurzschließt.

Der Zündabschnitt enthält also mindestens eine Kondensatorstufe und mindestens einen Querzweig, die an den Ladeleitungen angeschlossen sind. Danach erfolgt eine Aufteilung der Zweige, insbesondere verzweigen die gemeinsamen Ladeleitungen des Zündabschnitts in jeweilige einzelne Ladeleitungen für die Einzelabschnitte.

Über den Zündabschnitt erfolgt eine Kopplung der von diesem abzweigenden Zweige hinsichtlich der Zündung aller Funkenstrecken in den zugehörigen Querzweigen. So erfolgt eine synchronisierte Auslösung des Marx-Generators in den betreffenden Zweigen. Die von den betreffenden Zweigen bereitgestellten Marxspannungen werden in zeitlich definiert synchronisierte Weise bereitgestellt.

In einer bevorzugten Ausführungsform verzweigt einer der Querzweige des Marx-Generators vom Zündabschnitt in die Einzelabschnitte der zugehörigen Zweige. Ein Durchbruch bzw. Kurzschluss der Funkenstrecke in diesem Querzweig führt damit zu einem Kurzschluss zwischen dem Zündabschnitt und allen vom Zündabschnitt abzweigenden Einzelabschnitten der zugehörigen Zweige. Insbesondere ist dazu eine der beiden Elektroden der Funkenstrecke in diesem Querzweig mit einem Spannungs-Pol der der Abzweigung zugewandten Kondensatorstufe im Zündabschnitt verbunden. Die andere der beiden Elektroden ist mit je einem der Spannungs-Pole der jeweils nachfolgenden Kondensatorstufen in den Einzelabschnitten verbunden. So wird ein im Zündabschnitt initiierter Zündvorgang des Marx-Generators sicher in alle hiervon abzweigenden Einzelabschnitte weitergeleitet, so dass auch die Querzweige bzw. deren Funkenstrecken in den Einzelabschnitten sicher und insbesondere gleichzeitig zünden. Mit anderen Worten ist die eine Elektrode der Funkenstrecke am Zündabschnitt, die andere Elektrode an allen Einzelabschnitten angeschlossen.

In einer bevorzugten Ausführungsform sind die Funkenstrecken der Querzweige und/oder die Kondensatorstufen in den Zweigen so aufeinander abgestimmt, dass im regulären Betrieb des Marx-Generators wenigstens eine der Funkenstrecken im Zündabschnitt vor allen anderen Funkenstrecken zündet. Insbesondere zünden zwei oder mehr oder alle im Zündabschnitt vorhandenen Funkenstrecken entsprechen vor allen anderen Funkenstrecken in den Einzelabschnitten. Die frühere Zündung kann zum Beispiel durch eine geringere Zündspannung der einen oder mehreren Funkenstrecken eingestellt werden, welche vor anderen Funkenstrecken zünden sollen. Somit ist sichergestellt, dass sich die Zündung des Marx-Generators vom Zündabschnitt ausgehend in die Einzelabschnitte aufteilt, was zu einer besonders guten Gleichzeitigkeit der Zurverfügungstellung der Marxspannungen führt.

In einer bevorzugten Ausführungsform fallen die Zweige nicht nur hinsichtlich der ersten, sondern auch mindestens hinsichtlich wenigstens einer weiteren Kondensatorstufe zusammen, die der ersten Kondensatorstufe nachfolgt (zweite, dritte, vierte ... Kondensatorstufe). Weiterhin fallen die Zweige in diesem Fall auch hinsichtlich der zwischen den gemeinsamen Kondensatorstufen liegenden Querzweige zusammen. Der Zündabschnitt enthält dann also eine Anzahl von G (>1) Kondensatorstufen und mindestens G-1 Querzweige, die jeweils zwischen zwei der G Kondensatorstufen gemeinsam für die betreffenden Zweige im Zündabschnitt angeordnet sind. Danach erfolgt eine Aufteilung der Zweige, insbesondere verzweigen die gemeinsamen Ladeleitungen des Zündabschnitts in jeweiligen einzelnen Ladeleitungen für die Einzelabschnitte.

In einer bevorzugten Ausführungsform sind mindestens zwei der Zweige so dimensioniert, dass beim Betrieb des Marx-Generators die Marx-Spannungen an deren Ausgangspolen gleichzeitig bereitgestellt werden. Somit kann nicht nur eine zeitliche Synchronisation, sondern eine Gleichzeitigkeit der Marxspannungen erreicht werden. Insbesondere ist damit ein Zeitverlauf der Marx Spannungen phasengleich phasensynchronisiert. Dies eignet sich besonders zum Betrieb von Resonatoren als Pulsquellen des oben genannten Mikrowellen-Generators der DE 10 2018 004 568 A1. Dieser Mikrowellen-Generator kann Wellenleiter (Waveguides) enthalten, in dem die Resonatoren als Pulsquellen angeordnet sind. Der Generator kann insofern auch als Parallel-Feed-Waveguide bzw. Multi-Feed-Wellenleiter bezeichnet werden.

Diesbezüglich beschreibt die DE 10 2018 004 568 A1 also Pulsquellen zur jeweiligen Aussendung eines Pulsanteils. Jede der Pulsquellen kann z. B. durch einen Resonator dargestellt werden. In Bezug auf die vorliegende Erfindung wird dann zum Beispiel jeder der Resonatoren (hier werden insbesondere zwei Resonatoren betrachtet) von einem Ausgangspol des erfindungsgemäßen Marx-Generators gespeist. Der Marx-Generator enthält also dann genau zwei Zweige mit je einem Ausgang. Über den Zündabschnitt erfolgt die zeitliche Synchronisierung der beiden Pulsquellen. Insbesondere in dieser Hinsicht wird damit Bezug genommen auf die DE 10 2018 004 568 A1, deren Inhalt hiermit in diese Anmeldung aufgenommen wird.

In einer bevorzugten Ausführungsform weisen mindestens zwei, insbesondere alle, der Zweige eine identische Marx-Struktur auf. Die "Marx-Struktur" soll all diejenigen Merkmale umfassen, die hinsichtlich der Verwirklichung des Marx-Prinzip im Marx-Generator von Bedeutung sind. Insbesondere betrifft dies die gleiche Anzahl an Kondensatorstufen und Funkenstrecken in den betreffenden Zweigen, sowie die Dimensionierung der beteiligten Bauteile (Kapazitäten, Durchbruchspannungen, Abmessungen von Bauteilen, Längen von Leitungen, usw.). Dies führt zu einer weiter verbesserten Synchronisierung bzw. Gleichheit der im Marx-Generator erzeugten Marxspannungen.

In einer bevorzugten Ausführungsform ist die erste (also die dem Eingangspol im Zündabschnitt nachfolgende) Kondensatorstufe hinsichtlich bzw. über wenigstens eine der oben genannten Ladeleitungen über eine oben genannte Ladeimpedanz mit dem Eingangspol verbunden. So ist auch die erste Kondensatorstufe bezüglich einer betreffenden Ladecharakteristik vom Eingangspol her an die restlichen Kondensatorstufen angepasst.

In einer bevorzugten Ausführungsform enthält der Marx-Generator - neben den bisher genannten N-1 Querzweigen - einen weiteren Eingangs-Querzweig, der den Zweigen des Marx-Generators gemeinsam ist, da er im Zündabschnitt zwischen Eingangspol oder dessen Gegenpol und der ersten Kondensatorstufe angeordnet ist. Somit ist bereits die erste Kondensatorstufe über einen (Eingangs-)Querzweig mit dem Eingangspol verbunden. Der Eingangs-Querzweig ist ein zusätzlicher Querzweig, der hinsichtlich der oben genannten Überlegungen zur Anzahl von Querzweigen jeweils additiv hinzukommt.

In einer bevorzugten Ausführungsform weisen die Kondensatorstufen des Zündabschnittes jeweils für sich eine größere Kapazität als die restlichen Kondensatorstufen für sich auf. Dabei ist jeweils die betreffende Kapazität einer einzelnen Kondensatorstufe ("für sich"), nicht Gesamtkapazitäten in einem Zweig oder Abschnitt, gemeint. Die entsprechend im Zündabschnitt (in dessen Kondensatorstufen) gespeicherte Energie kann dann bei Auslösen des Marx-Generators (Zünden der Funkenstrecken) auf die Einzelabschnitte verteilt werden. Insbesondere ist die Kapazität einer jeweiligen Kondensatorstufe des Zündabschnitts doppelt so groß wie die einer jeweiligen Kondensatorstufen in den Einzelabschnitten. Dies gilt insbesondere bei zwei Zweigen bzw. Einzelabschnitten.

In einer bevorzugten Ausführungsform sind die Kondensatorstufen mindestens eines der Zweige räumlich entlang einer Verlaufslinie angeordnet. Am jeweils einen Ender der Verlaufslinie befindet sich die letzte Kondensatorstufe des Zweiges und der Ausgangspol. Am jeweils anderen Ende die erste Kondensatorstufe und der Gegenpol zum Ausgangspol. Der Abstand zwischen dem Ausgangspol und seinem Gegenpol ist kleiner als die Längsausdehnung des Zweiges entlang der Verlaufslinie.

Der jeweilige Zweig des Marx-Generators ist damit hinsichtlich seiner Kondensatorstufen sinngemäß entsprechend der nachveröffentlichten DE 10 2021 004 466.5 (Anmeldetag am Deutschen Patent- und Markenamt: 02.09.2021, Titel: "Pulsgenerator für einen HPEM-Puls") ausgeführt. D. h., die Kondensatoren in Form von Kondensatorstufen sind auch vorliegend räumlich entlang einer Verlaufslinie angeordnet, an deren beiden Enden sich jeweils Ausgangspol und Gegenpol für die Marxspannung befinden, wobei der Abstand zwischen Ausgangspol und Gegenpol kleiner als die Längsausdehnung des Marx-Generators (Zweiges) entlang der Verlaufslinie ist. Das grundlegende Prinzip einer solchen Anordnung entlang einer Verlaufslinie (Kreis, S-Form, Zick-Zack) ist in der DE 10 2021 004 466.5 insbesondere anhand der Figuren 2-5 und der zugehörigen Beschreibung erläutert. In dieser Hinsicht wird Bezug genommen auf die Anmeldung DE 10 2021 004 466.5, deren Inhalt hiermit in diese Anmeldung aufgenommen wird. Der diesbezügliche Offenbarungsgehalt der DE 10 2021 004 466.5 wird aufgenommen, sofern dies nicht im Widerspruch zur vorliegenden Anmeldung, insbesondere zu der vorliegenden Ergänzung um den Zündabschnitt steht. Insbesondere wird auch der Inhalt betreffend dem unten vorgeschlagenen Resonator bzw. dessen Anordnung zur Verlaufslinie / den Kondensatorstufen sinngemäß übernommen.

Die Aufgabe der Erfindung wird auch gelöst durch eine Resonatoranordnung gemäß Patentanspruch 11. Diese enthält einen erfindungsgemäßen Marx-Generator und mit wenigstens zwei Resonatoren, wobei jeder der Resonatoren an einem jeweiligen Ausgangspol eines der Zweige angeschlossen ist. In den entsprechenden Zweigen ist also stets ein Resonator pro Zweig angeordnet bzw. an dessen Ausgangspol (und dem Gegenpol) angeschlossen.

Durch das zeitlich synchronisierte Zünden des Marx-Generators werden auch die erzeugten Marxspannungen zeitlich synchronisiert, insbesondere gleichzeitig, an den Resonatoren bereitgestellt.

Die Resonatoranordnung und zumindest ein Teil deren möglicher Ausführungsformen sowie die jeweiligen Vorteile wurden sinngemäß bereits im Zusammenhang mit dem erfindungsgemäßen Marx-Generator erläutert.

Die Aufgabe der Erfindung wird auch gelöst durch eine Strahlungsanordnung gemäß Patentanspruch 12. Diese enthält eine erfindungsgemäße Resonatoranordnung und einen Multi-Feed-Wellenleiter, der wenigstens zwei der Resonatoren zur jeweiligen Einspeisung einer elektromagnetischen Welle enthält. Der Multi-Feed-Wellenleiter ist insbesondere - wie oben erwähnt - als Mehrzahl von Wellenleitern (insbesondere zwei) Teil des Generators der DE 10 2018 004 568 A1.

Die Strahlungsanordnung und zumindest ein Teil deren möglicher Ausführungsformen sowie die jeweiligen Vorteile wurden sinngemäß bereits im Zusammenhang mit der erfindungsgemäßen Resonatoranordnung erläutert.

In einer bevorzugten Ausführungsform umgreift für mindestens zwei der Zweige jeder dieser Zweige einen der Resonatoren zumindest teilweise; und der Zündabschnitt verläuft zwischen den Resonatoren. Hierdurch ergibt sich eine besonders vorteilhafte geometrische Anordnung der Zweige. Insbesondere erfolgt hier eine Umsetzung des Anordnungskonzepts für Kondensatorstufen, wie es für Kondensatoren aus der DE 10 2021 004 466.5 bekannt ist. Die dort beschriebene Verlaufslinie umgreift bzw. umringt also den jeweiligen Resonator. Vorliegend sind im Zündabschnitt die Verlaufslinien dann insbesondere deckungsgleich.

In einer bevorzugten Variante dieser Ausführungsform sind die Zweige achsensymmetrisch zu einer zwischen den Resonatoren verlaufenden Symmetrieachse angeordnet. Der Zündabschnitt verläuft dabei entlang der Symmetrielinie. Sodann teilen sich die Einzelabschnitte symmetrisch von dort aus auf. Mit anderen Worten verlaufen auch die Verlaufslinien achsensymmetrisch zu der entsprechenden Symmetrieachse. Insbesondere ist die Verlaufslinie im Bereich des Zündabschnitts eine Gerade, die mit der Symmetrieachse zusammenfällt. So ergibt sich eine besonders vorteilhafte Anordnung zur Speisung von zwei Resonatoren in niederinduktiver Weise aus zwei Teilen bzw. Zweigen bzw. Ausgangspolen des erfindungsgemäßen Marx-Generators. Auch hier ist der Marx-Generator insbesondere mit genau zwei Zweigen ausgeführt.

Die Erfindung beruht auf folgenden Erkenntnissen, Beobachtungen bzw. Überlegungen und weist noch die nachfolgenden bevorzugten Ausführungsformen auf. Diese Ausführungsformen werden dabei teils vereinfachend auch "die Erfindung" genannt. Die Ausführungsformen können hierbei auch Teile oder Kombinationen der oben genannten Ausführungsformen enthalten oder diesen entsprechen und/oder gegebenenfalls auch bisher nicht erwähnte Ausführungsformen einschließen.

Vorliegend wird die Erfindung - ohne Einschränkung ihrer Allgemeingültigkeit und lediglich beispielhaft - auch näher erläutert anhand eines Parallel-Feed-Waveguide, wie er z. B. aus der oben genannten DE 10 2018 004 568 A1 als Generator mit zwei Pulsquellen in Form von Resonatoren bekannt ist. Die Erfindung ist jedoch auf jegliche Marx-Generatoren anwendbar, deren Ausgangsspannungen zeitlich synchronisiert bereitgestellt werden sollen.

Die Erfindung beruht auf der Überlegung, dass die aus der DE 10 2018 004 568 A1 bekannte Strahlungsquelle mit elektrischer Energie versorgt werden muss. Denkbar wäre es, hierzu einen Marx-Generator zu nutzen. Z. B. im Falle von zwei Pulsquellen in Form von zwei Resonatoren wäre dann folgendes denkbar: Die beiden Resonatoren einer Hornantenne mit Parallel-Feed-Waveguide erhöhen die in die Antenne eingespeiste Hochfrequenz-Leistung um ideal den Faktor 2 gegenüber einem Resonator mit vergleichbaren Betriebsparametern. Aus der Praxis bisher bekannt ist es, Marx-Generatoren in linearer Anordnung zu bauen, und diese in ihrer Ausgangskapazität für einen bis N Resonatoren zu konzipieren. Ein Marx-Generator könnte beispielsweise die zwei Resonatoren ähnlich schnell auf Hochspannung laden wie ein (linearer) Marx-Generator einen einzelnen Resonator laden könnte. Damit stünde durch die beiden Resonatoren annähernd die doppelte Hochfrequenz-Pulsleistung zur Verfügung, die - bei gleicher Antennenapertur - knapp Wurzel-2-fache Feldstärke abstrahlen könnte. Damit ist eine knapp Wurzel-2-fache Reichweite möglich.

Die Erfindung beruht nun auf der Erkenntnis, dass durch den Betrieb mit einem gemeinsamen, linearen Marx-Generator die Ladegeschwindigkeit der beiden Resonatoren jedoch relativ langsam ist. Eine weitere Erkenntnis ist: Gemäß dem sogenannten Zeit-Flächen-Gesetz nach Dieter Kind aus dem Jahre 1957 (Kind, "Die Aufbaufläche bei Stoßspannungsbeanspruchung technischer Elektrodenanordnungen in Luft ", Dissertationsschrift, TH München, 1957) ist folgendes bekannt: Die Spannungs-Zeit-Fläche ab Überschreiten der DC-Durchbruchsspannung einer Funkenstrecke ist konstant. Gleichbedeutend ist: Wenn diese DC-Durchbruchsspannung in einem sehr schnellen Puls überschritten wird, ist die tatsächliche Durchbruchsspannung deutlich erhöht. Dies führt im Fall von funkenstreckenbasierten Resonatoren zu einer größeren HF-Amplitude.

Aus der DE 10 2018 004 568 A1 lässt sich zusätzlich folgendes schließen bzw. wird folgende Erkenntnis gezogen: Die Leistungseinkopplung in HPEM-Antennensysteme lässt sich durch die Kombination von Resonatoren erhöhen und damit abgestrahlte Feldstärke wie Reichweite mit zirka der Wurzel der Anzahl der Resonatorsysteme steigern. Die Anzahl an Resonatoren müssen jedoch phasenrichtig zünden. Im Fall von zwei Resonatoren im Parallel-Feed-Waveguide müssen diese z. B. zeitgleich zünden.

Die Erfindung beruht nun auf der Idee, das dieses zeitgleiche Zünden durch das gemeinsame schnelle Aufladen durch einen gemeinsamen Marx-Generator erzielt werden könnte.

Die DE 10 2021 004 466.5 schlägt ein Konzept (auch "Koaxialer Marx-Generator / Koaxial-Marx / Ring-Marx") vor, die Leistung eines Einzelresonators dadurch zu steigern, dass der Marx-Generator extrem niederinduktiv an den Resonator angebunden ist. Hieraus wird folgende Erkenntnis gewonnen: Dies wird dadurch erzielt, dass der Marx-Generator z. B. quasi koaxial um den Resonator gewickelt wurde. Die elektrische Schaltung bleibt dabei identisch zu einem linearen Marx-Generator. Die höhere Feldstärke ergibt sich einzig aus der geringeren Induktivität des Marx-Generators inklusive der Verkabelung zum Resonator und damit dem schnelleren Ladepuls am Resonator, der analog zum Spannungs-Zeit-Flächen-Gesetz nach [Kind 1957, siehe oben] eine höhere Zündspannung und eine höhere HF-Amplitude erzeugt.

Aus der Praxis hat sich noch folgende Erkenntnis ergeben: Mit einem koaxialen Marx-Generator beträgt die gemessene Feldstärke- und damit Reichweitensteigerung je nach Typ und Stufenanzahl eines linearen Marx-Generators als Vergleichsbasis ca. den Faktor 2. Dies entspricht einer Steigerung der HF-Leistung des abgestrahlten Feldes um einen Faktor 4 bzw. 6 dB. Der Leistungsfaktor 4 (erzielt mit nur einem Resonator und einem Koaxial-Marx-Generator) bedürfte bei einem Parallel-Feed-Waveguide und Verwendung bisheriger linearer Marx-Generatoren bereits 4 perfekt synchronisierte und phasentreue Resonatoren.

Gemäß der Erfindung ist das niederinduktive Konzept eines Koaxial-Marx-Generators für Einzelresonatoren nun auch z. B. für die beiden Resonatoren einer Hornantenne mit Parallel-Feed-Waveguide nutzbar. Damit kann die Leistung jedes der beiden Resonatoren nahe an das maximal mögliche bei Einzelresonatorbetrieb angehoben werden, um die doppelte Anzahl der Resonatoren näherungsweise in die doppelte eingespeiste Leistung in die Antenne umsetzen bzw. nutzen zu können.

Gemäß der Erfindung wird daher insbesondere ein Doppelt-Koaxial-Marx-Generator geeignet um zwei Resonatoren angeordnet. Gemäß der Erfindung kann der Vorteil der niederinduktiven, koaxialen Marx-Generatoren gemäß DE 10 2021 004 466.5 mit dem Vorteil zweier Resonatoren in einem Parallel-Feed-Waveguide gemäß DE 10 2018 004 568 A1 gemeinsam genutzt werden. Der erfindungsgemäße Marx-Generator wird daher als "Doppelt-Koaxial-Marx-Generator" bezeichnet.

Der erfindungsgemäße "Doppelt-Koaxial-Marx-Generator" beginnt mit der Zündung wenigstens einer ersten, insbesondere der ersten drei (oder mehr) gemeinsamen Stufen (im Zündabschnitt) und stabilisiert damit das Timing. Anschließend teilt sich die weitere Spannungserhöhung in zwei (insbesondere kleinere) Marx-Generator-Äste / Zweige (Einzelabschnitte), die sich insbesondere wie eine "8" oder doppelt koaxial um die beiden Resonatoren herumwickeln.

Die Erfindung beruht noch auf der Erkenntnis, dass ein klassischer linearer Marx-Generator die Eingangsspannung üblicherweise entsprechend der Stufenzahl, jedoch in einer linearen Kette, multipliziert. Der Begriff linear ist hier schaltungstechnisch, nicht geometrisch zu verstehen. Der Koaxial-Marx ist bezüglich der elektrischen Schaltung ebenfalls linear und damit identisch zur Schaltung der als geometrisch linear bezeichneten Marx-Generatoren.

Gemäß der Erfindung wird der Marx-Generator nach einer gewissen Stufenanzahl, z. B. drei Stufen, nämlich am Ende des Zündabschnitts in mehrere, insbesondere zwei Zweige mit weiteren Stufen (Einzelabschnitte, z. B. 9 Stufen pro Einzelabschnitt), aufgeteilt, und die aufgeteilten Zweige wickeln sich insbesondere analog zur DE 10 2021 004 466.5 um die beiden Resonatoren, die z. B. in der Konfiguration "2-fach Parallel-Feed" nach DE 10 2018 004 568 A1 angeordnet sind.

Durch diese doppelt-koaxiale Konfiguration ist ein schnelles und möglichst gleichzeitiges Laden der beiden Resonatoren möglich. Damit können die Resonatoren mit hoher Einzelamplitude und möglichst phasensynchron zünden und sich die Feldamplituden addieren.

Die Erfindung könnte z. B. als leistungssteigernde Komponente für eine HPEM-Quelle für Drohnenabwehr (C-UAS: Countering Unmanned Aerial System, oder CUAV: Countering Unmanned Aerial Vehicle) eingebaut werden.

Gemäß der Erfindung ergibt sich damit ein - insbesondere niederinduktiver, bei Ringanordnung eines Marx-Generators gemäß DE 10 2021 004 466.5 - Doppelt-Koaxial-Marx-Generator für einen Parallel-Feed-Waveguide. Der Parallel-Feed-Waveguide mit mehreren Resonatoren an einer gemeinsamen Hornantenne gemäß der DE 10 2018 004 568 A1 erhöht die abgestrahlte Feldstärke.

Weitere Merkmale, Wirkungen und Vorteile der Erfindung ergeben sich aus der nachfolgenden Beschreibung eines bevorzugten Ausführungsbeispiels der Erfindung sowie der beigefügten Figuren. Dabei zeigen, jeweils in einer schematischen Prinzipskizze:
- Figur 1: ein Schaltbild eines Marx-Generators mit zwei Zweigen, die zwei Resonatoren mit Energie versorgen,
- Figur 2: eine symbolische Ansicht von unten einer Strahlungsanordnung mit einem alternativen Marx-Generator,
- Figur 3a: die Strahlungsanordnung aus Figur 2 in vereinfachter Darstellung in Schrägansicht von oben,
- Figur 3b: in Ansicht von unten, und
- Figur 3c: in Ansicht von vorne.

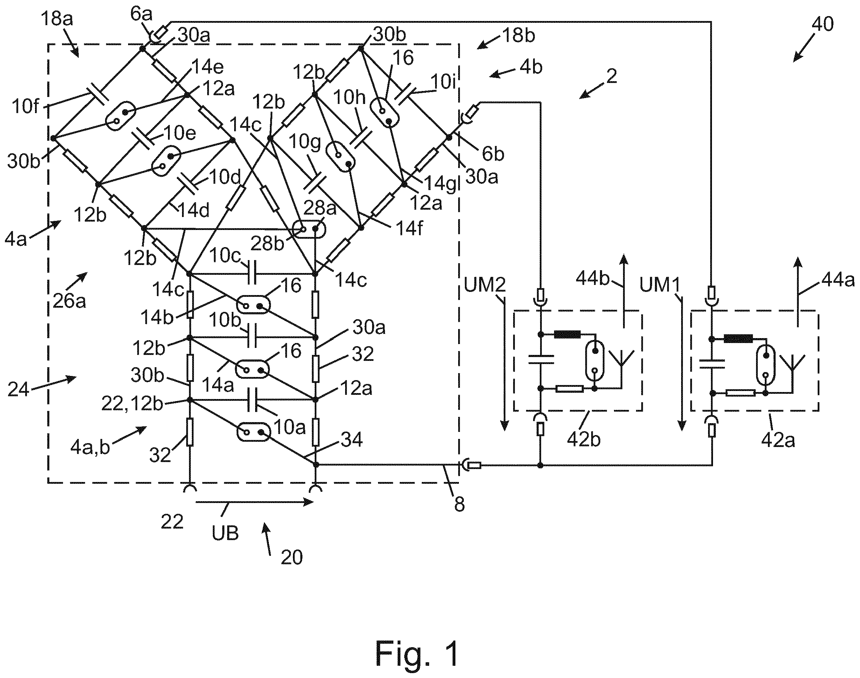

Figur 1 zeigt ein Schaltbild eines Marx-Generators 2. Der Marx-Generator 2 weist zwei Zweige 4a,b auf. Jeder der zwei Zweige 4a,b dient zur Abgabe einer jeweiligen Marxspannung UM1,2. Hierzu weist jeder der Zweige 4a,b einen jeweiligen Ausgangspol 6a,b auf, an dem im Betrieb des Marx-Generators 2 ein der Marxspannung UM1,2 entsprechendes Potential anliegt. Die Marxspannung UM1,2 stellt sich dann genauer gesagt zwischen dem jeweiligen Ausgangspol 6a,b und einem Gegenpol 8 ein. Jeder der Zweige 4a,b enthält mehrere, hier jeweils sechs (im Sinne eines Marx-Generators) in Reihe geschaltete Kondensatorstufen 10. Der Zweig 4a enthält dabei die Kondensatorstufen 10a-f, der Zweig 4b die Kondensatorstufen 10a-c und 10g-i. Jede der Kondensatorstufen 10 enthält jeweils einen ersten Spannungs-Pol 12a und einen zweiten Spannungs-Pol 12b.

Jeder der Zweige 4a,b enthält weiterhin fünf Querzweige 14. Der Zweig 4a enthält dabei die Querzweige 14a-e, der Zweig 4b enthält die Querzweige 14a-c und 14f-g. Jeweils zwei benachbarte Kondensatorstufen 10 sind durch je einen der Querzweige 14 verbunden. Jeder der Querzweige 14 führt vom ersten Spannungs-Pol 12a der jeweils vorhergehenden (Zählreihenfolge vom Eingangspol 22 (siehe unten) zum Ausgangspol 6a,b, hier in der Reihenfolge aufsteigender Buchstaben) zum zweiten Spannungs-Pol 12b der jeweils nachfolgenden Kondensatorstufe 10. So führt beispielsweise der Querzweig 14a vom ersten Pol 12a der ersten Kondensatorstufe 10a zum zweiten Pol 12b der zweiten Kondensatorstufe 10b.

Jeder der Querzweige 14 enthält eine Funkenstrecke 16. Jeder der Zweige 4a,b enthält jeweils eine letzte Kondensatorstufe 10, beim Zweig 4a ist dies die Kondensatorstufe 10f, beim Zweig 4b die Kondensatorstufe 10i. Der jeweilige Spannungs-Pol 12a der jeweiligen letzten Kondensatorstufe 10f,i bildet den jeweiligen Ausgangspol 6a,b der Zweige 4a,b.

Der Marx-Generator 2 bzw. jeder Zweig 4a,b für sich ist jeweils nach Art eines fachüblichen Marx-Generators aufgebaut: Dies bedeutet, dass sämtliche Spannungs-Pole 12a über jeweilige Ladeleitungen 30a miteinander über Ladeimpedanzen 32 verbunden sind. Ebenso sind die Spannungs-Pole 12b über eine Ladeleitung 30b und jeweils zwischengeschaltete Ladeimpedanzen 32 verbunden.

Jeder der Zweige 4a,b enthält auch eine erste Kondensatorstufe 10a, die hier für beide Zweige 4a,b identisch ist. Somit ergibt sich ein jeweiliges Ausgangsende 18a,b an den Kondensatorstufen 10f,i bzw. an den Ausgangspolen 6a,b sowie ein Eingangsende 20 (für beide Zweige 4a,b gleich) an der Kondensatorstufe 10a und an einem Eingangspol 22 für beide Zweige 4a,b. Der eine Pol der ersten Kondensatorstufe 10a, hier der Pol 12b ist mit dem Eingangspol 22 zur Einspeisung einer Betriebsspannung UB verbunden. Auch die Betriebsspannung UB wird dabei entsprechend zu oben zwischen dem Eingangspol 22 und einem Gegenpol 8 (hier identisch zu dem oben für die Ausgangspole 6a,b) angelegt.

Sowohl die Marxspannungen UM1,2 als auch die Betriebsspannung UB ist also jeweils auf ein Potenzial des Gegenpols 8 bezogen. Vorliegend fallen die Gegenpole 8 sowohl für den Eingangspol 22 als auch die Ausgangspole 6a,b zusammen.

Die beiden Zweige 4a,b weisen einen gemeinsamen Zündabschnitt 24 auf. In dem Zündabschnitt 24 fallen die beiden Zweige 4a,b wie folgt zusammen: Sie weisen die erste bis dritte Kondensatorstufe 10a-c gemeinsam auf sowie die beiden dazwischenliegenden Querzweige 14a,b und somit auch den, der ersten Kondensatorstufe 10a benachbarten ersten Querzweig 14a. Auch den Eingangspol 22 weisen die beiden Zweige 4a,b im Zündabschnitt 24 gemeinsam auf bzw. fallen bezüglich diesem zusammen.

Die Zweige 4a,b fallen also auch nicht nur hinsichtlich der ersten Kondensatorstufe 10a, sondern auch hinsichtlich der beiden nachfolgenden Kondensatorstufen 10b,c zusammen. Ebenso fallen sie hinsichtlich der zwischen den gemeinsamen Kondensatorstufen 10a-c liegenden Querzweige 14a,b zusammen.

Jeder der Zweige 4a,b weist neben dem Zündabschnitt 24 auch einen jeweiligen Einzelabschnitt 26a,b auf, der weitere Kondensatorstufen 10 enthält. Dem Einzelabschnitt 26a sind dabei die Kondensatorstufen 10d-f, dem Einzelabschnitt 26b die Kondensatorstufen 10g-i zugeordnet. Im Beispiel sind auch die jeweils dazwischenliegenden Querzweige 14d,e dem Einzelabschnitt 26a und die Querzweige 14f,g dem Einzelabschnitt 26b zugeordnet.

Einer der Querzweige, nämlich der Querzweig 14c, verzweigt sich dabei vom Zündabschnitt 24 in die Einzelabschnitte 26a,b. Dies ist wie folgt bewerkstelligt: Eine Elektrode 28a der zugehörigen Funkenstrecke 16 ist mit dem Spannungs-Pol 12a der Kondensatorstufe 10c des Zündabschnitts 24 verbunden. Die andere Elektrode 28b ist mit dem zweiten Spannungs-Pol 12b der Kondensatorstufe 10d des Einzelabschnitts 26a und dem zweiten Spannungs-Pol 12b der Kondensatorstufe 10g des Einzelabschnitts 26b verbunden.

Die Funkenstrecken 16 der Querzweige 14a-g und die Kondensatorstufen 10a-i sind so aufeinander abgestimmt, dass im regulären Betrieb des Marx-Generators 2 wenigstens eine der Funkenstrecken 16 im Zündabschnitt 24 vor allen anderen Funkenstrecken 16 des Marx-Generators 2 zündet. Hierdurch wird erreicht, dass sich die Zündung des Marx-Generators vom Zündabschnitt 24 aus gleichzeitig und gleichmäßig in die Einzelabschnitte 26a,b fortsetzt.

Die Zweige 4a,b sind so dimensioniert, dass beim Betrieb des Marx-Generators 2 die Marxspannungen UM1,2 an deren Ausgangspolen 6a,b gleichzeitig bereitgestellt werden. Dies wird vorliegend erreicht durch eine symmetrische Dimensionierung sämtlicher Bauteile in den Zweigen 4a,b sowie die gleiche Anzahl von Kondensatorstufen 10 und Querzweigen 14 sowie den gleichen Kapazitäten und Schaltcharakteristiken von diesen. Ebenso gilt dies für die Dimensionierung der Ladeleitungen 30a,b mit ihren Ladeimpedanzen 32.

Insofern weisen die beiden Zweige 4a,b identische Marxstruktur auf, sind also schaltungstechnisch sowie auch hinsichtlich ihrer Dimensionierung identische "Einzel-Marx-Generatoren".

Vorliegend ist ergänzend die erste Kondensatorstufe 10a hinsichtlich der Ladeleitungen 12a,b über weitere Ladeimpedanzen 32 mit dem Potentialeingang 22 sowie dem Gegenpol 8 verbunden.

Ebenso weist vorliegend der Marx-Generator 2 einen weiteren, den Zweigen 4a,b gemeinsamen Eingangs-Querzweig 34 auf, der sich zwischen dem Eingang für die Betriebsspannung UB (Eingangspol 22, Gegenpol 8), hier dem Gegenpol 8 und der ersten Kondensatorstufe 10a, hier deren Spannungs-Pol 12b, erstreckt.

Vorliegend weist jede der Kondensatorstufen 10a-c des Zündabschnitts 24 für sich jeweils eine größere, nämlich die doppelte Kapazität auf als jede der restlichen Kondensatorstufen 10d-i, jeweils für sich.

Figur 1 zeigt auch eine Resonatoranordnung 40. Diese enthält den Marx-Generator 2 sowie zwei Resonatoren 42a,b. Jeder der Resonatoren 42a,b ist an einem jeweiligen Ausgangspol 6a,b eines der Zweige 4a,b (und dem Gegenpol 8) angeschlossen. Im Betrieb werden daher die Resonatoren 42a,b durch die beiden Marxspannungen UM1,2 aus den Zweigen 4a,b des Marx-Generators 2 mit Energie versorgt, um eine jeweilige elektromagnetische Welle 44a,b auszugeben. Letztere ist in Figur 1 nur symbolisch durch einen Pfeil angedeutet.

Zwei elektrische Kreise in Figur 1 sind somit gebildet aus dem Marx-Generator 2 und den jeweils am Ausgangsende 18a,b angeschlossen Resonatoren 42a,b mit integrierter Antenne (symbolisch dargestellt) zur Abstrahlung der Wellen 44a,b. Die Antenne ist eine integrierte Monopolantenne zur Wellenleiter-Kopplung, d. h. Kopplung der Wellen 44a,b in die Hohlleiter der Wellenleiter 52.

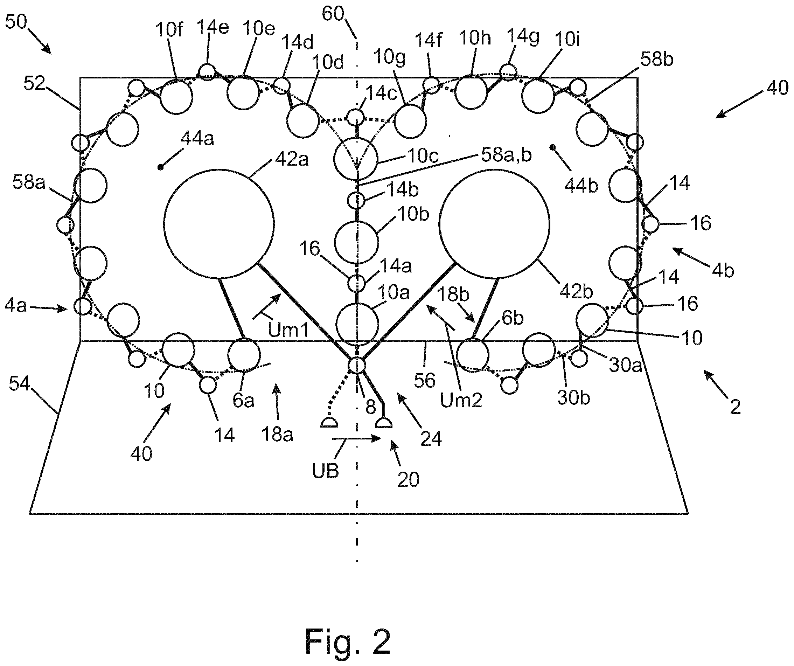

Figur 2 zeigt eine Strahlungsanordnung 50. Diese enthält eine Resonatoranordnung 40, die prinzipiell derjenigen aus Figur 1 entspricht, jedoch wie folgt alternativ ausgestaltet ist: Deren Marx-Generator 2 weicht von demjenigen aus Figur 1 dadurch ab, dass die Zweige 4a,b nicht mit der jeweiligen Kondensatorstufe 10f oder 10i enden, sondern sich an diese nochmals pro Zweig 4a,b je sechs weitere Kondensatorstufen 10 und sechs Querzweige 14 anschließen, bis schließlich die Ausgangsenden 18a,b mit den entsprechenden Ausgangspolen 6a,b erreicht sind. Ansonsten ist die Resonatoranordnung 40 identisch zu Figur 1 ausgestaltet.

Die Strahlungsanordnung 50 enthält neben der Resonatoranordnung 40 außerdem einen Wellenleiter 52, hier einen Multi-Feed-Wellenleiter. Dieser enthält die beiden Resonatoren 42a,b der Resonatoranordnung 40. Die Resonatoren 42a,b dienen hierbei zur jeweiligen Einspeisung der Wellen 44a,b in den Wellenleiter 52. Am Wellenleiter 52 ist eine Hornstruktur 54 angeschlossen, die über eine Verbindungsöffnung 56 miteinander verbunden sind. Im Betrieb treten die Wellen 44a,b über die Verbindungsöffnung 56 in die Hornstruktur 54 aus und überlagern sich und werden über welche die Hornstruktur 54 in nicht näher erläuterter Weise abgestrahlt. Somit ergibt sich eine Strahlungsquelle vergleichbar zu denen aus DE 10 2018 00456 8 A1.

In dieser Ausführungsform sind die Kondensatorstufen der Zweige 4a,b räumlich entlang einer jeweiligen Verlaufslinie 58a,b (in der Figur doppelt strichpunktiert dargestellt) angeordnet, die hier in etwa einer einseitig abgeflachten Kreisform aufweist bzw. dieser folgt, dabei am "Beginn" also einen geraden Abschnitt aufweist. Dieser betrifft die drei Kondensatorstufen 10a-c im Zündabschnitt 24. Am jeweiligen "Ende" der Verlaufslinie 58a,b befindet sich jeweils der Ausgangspol 6a,b bzw. das jeweilige Ausgangsende 18a,b, am jeweiligen Beginn der Gegenpol 8 bzw. das Eingangsende 20. Der Abstand zwischen dem jeweiligen Ausgangspol 6a,b und dem Gegenpol 8 ist jeweils kleiner als die Längsausdehnung des Zweiges 4a,b entlang der Verlaufslinie 58a,b.

Die beiden Zweige 4a,b umgreifen also entlang der Verlaufslinien 58a,b die jeweiligen Resonatoren 42a,b teilweise. Der Zündabschnitt 24 verläuft zwischen den Resonatoren 42a,b. Bezüglich einer Symmetrieachse 60 sind die Zweige 4a,b achsensymmetrisch angeordnet. Die Symmetrieachse 60 fällt mit dem jeweiligen gemeinsamen geraden Verlaufsabschnitt der Verlaufslinien 58a,b im Zündabschnitt 24 zusammen.

Figur 2 zeigt damit einen sogenannten Doppelt-Koaxial-Marx-Generator 2, bei dem die Kondensatoren der hier als Kreise symbolisch angedeuteten Kondensatorstufen 10 um die beiden Resonatoren 42a,b herum angeordnet sind (entlang der jeweiligen Verlaufslinie 58a,b). Die jeweiligen Kondensatoren bzw. Kondensatorstufen 10a-c weisen (jeweils pro Kondensatorstufe 10 einzeln betrachtet) eine größere, hier doppelte Kapazität, als die jeweiligen restlichen Kondensatorstufen 10 auf. Die Funkenstrecken 16 sind hier ebenfalls symbolisch als Kreise in den Querzweigen 14 dargestellt. Die Ladeleitungen 30a,b sind hier nur symbolisch dargestellt und verlaufen tatsächlich vollständig oberhalb der Papierebene (Ladeleitung 30b, fett gepunktet) und unterhalb der Papierebene (Ladeleitung 30a, fett ausgezogen dargestellt). Sie sind jeweils nur zur Hälfte dargestellt, was funktional die Entladung des Marx-Generators 2 über die Querzweige 14 darstellen soll.

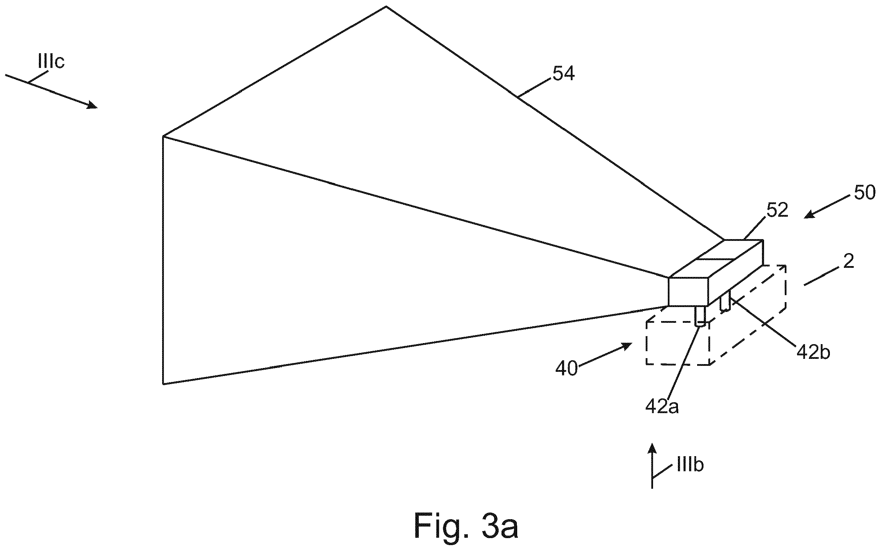

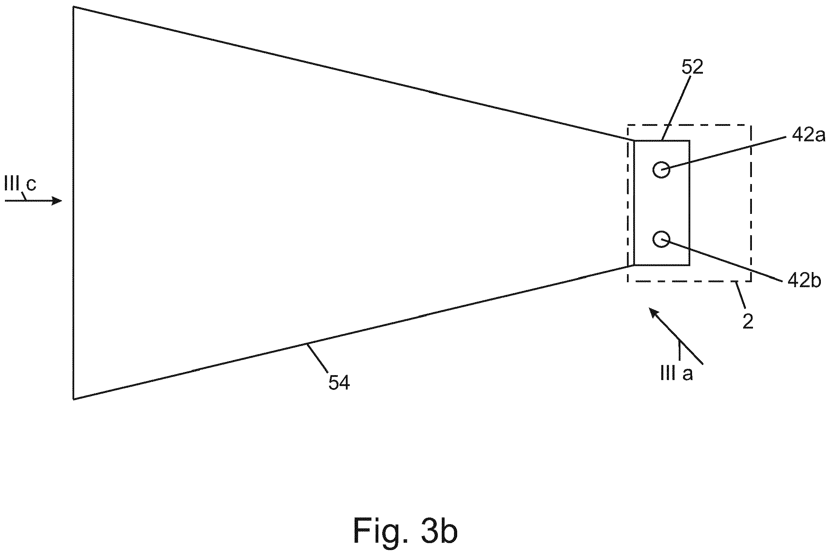

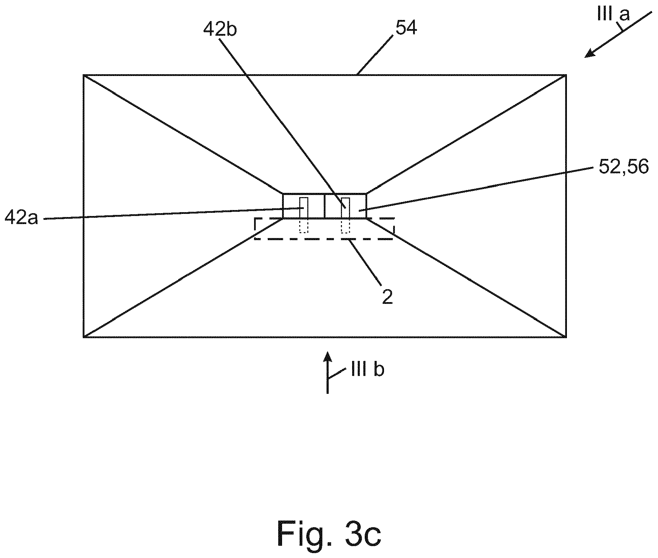

Figur 3 zeigt die Strahlungsanordnung 50 aus Figur 2 in perspektivischer, jedoch symbolischer Ansicht, indem der Marx-Generator 2 nur symbolisch durch einen gestrichelten Quader angedeutet ist. In Figur 3 ist die gesamte Hornstruktur 54 zu erkennen. Figur 3a zeigt eine Schrägansicht von hinten oben in Blickrichtung der Pfeile Illa, Figur 3b eine Ansicht von unten (Blickrichtung der Pfeile IIIb) entsprechend der Figur 2, Figur 3c eine Ansicht von vorne (Blickrichtung der Pfeile IIIC). Die Resonatoren 42a,b sind identische Resonatoren für Hohlleiterantennen. Der Multi-Feed-Wellenleiter 52 ist hier aus zwei einzelnen Wellenleitern gebildet, die nebeneinander angeordnet sind (parallel Waveguide), mit je einem Resonator 42a,b, die von dem gemeinsamen Marx-Generator 2 mit einem Hochspannungspuls geladen werden. Die Hornstruktur 54 ist hier ein Horntrichter.

In den Figuren 3a,b ist der Marx-Generator 2 sichtbar und nur deshalb gestrichelt angedeutet, um den Blick auf die Resonatoren 42a,b freizugeben. In Figur 3c ist der Marx-Generator 2 tatsächlich nicht sichtbar, da er von der Hornstruktur 54 verdeckt ist.

### Bezugszeichenliste

- 2: Marx-Generator
- 4a,b: Zweig
- 6a,b: Ausgangspol
- 8: Gegenpol
- 10a-i: Kondensatorstufe
- 12a,b: Spannungs-Pol
- 14a-g: Querzweig
- 16: Funkenstrecke
- 18a,b: Ausgangsende
- 20: Eingangsende
- 22: Eingangspol
- 24: Zündabschnitt
- 26a,b: Einzelabschnitt
- 28a,b: Elektrode
- 30a,b: Ladeleitung
- 32: Ladeimpedanz
- 34: Eingangs-Querzweig
- 40: Resonatoranordnung
- 42a,b: Resonator
- 44a,b: Welle
- 50: Strahlungsanordnung
- 52: Wellenleiter
- 54: Hornstruktur
- 56: Verbindungsöffnung
- 58a,b: Verlaufslinie
- 60: Symmetrieachse

- UM1,2: Marx-Spannung
- UB: Betriebsspannung

## Patentansprüche

1. Marx-Generator (2),
- mit mindestens zwei Zweigen (4a,b) zur Abgabe einer jeweiligen Marx-Spannung (UM1,2) an einem jeweiligen Ausgangspol (6a,b) des Zweiges (4a,b),
- wobei jeder der Zweige (4a,b) enthält:
- mehrere in Reihe geschaltete Kondensatorstufen (10), die jeweils mindestens einen ersten (12a) und einen zweiten Spannungs-Pol (12b) aufweisen,
- jeweilige Querzweige (14), wobei jeweils zwei benachbarte Kondensatorstufen (10) zwischen dem ersten Spannungs-Pol (12a) der vorhergehenden und dem zweiten Spannungs-Pol (12b) der nachfolgenden Kondensatorstufe (10) durch einen der Querzweige (14) verbunden sind, wobei jeder der Querzweige (14) eine Funkenstrecke (16) enthält,
- eine letzte Kondensatorstufe (10) an seinem Ausgangsende (18a,b), deren einer Spannungs-Pol (12a,b) den jeweiligen Ausgangspol (6a,b) des Zweiges (4a,b) bildet,
- eine erste Kondensatorstufe (10) an seinem Eingangsende (20), deren einer Spannungs-Pol (12a,b) mit einem Eingangspol (22) zur Einspeisung einer Betriebsspannung (UB) verbunden ist,
- wobei mindestens zwei der Zweige (4a,b) einen gemeinsamen Zündabschnitt (24) aufweisen, in dem sie mindestens hinsichtlich der ersten Kondensatorstufe (10) und eines ersten benachbarten Querzweiges (14) und des Eingangspols (22) zusammenfallen,
- und jeder der Zweige (4a,b) mit Zündabschnitt (24) auch einen Einzelabschnitt (26a,b) aufweist, der mindestens eine, nur diesem zugeordnete Kondensatorstufe (10) enthält.

2. Marx-Generator (2) nach Anspruch 1,
**dadurch gekennzeichnet, dass**
einer der Querzweige (14) sich vom Zündabschnitt (24) in die Einzelabschnitte (26a,b) verzweigt.

3. Marx-Generator (2) nach einem der vorhergehenden Ansprüche,
**dadurch gekennzeichnet, dass**
die Funkenstrecken (16) der Querzweige (14) und/oder die Kondensatorstufen (10) so aufeinander abgestimmt sind, dass im regulären Betrieb des Marx-Generators (2) wenigstens eine der Funkenstrecken (16) im Zündabschnitt (24) vor allen anderen Funkenstrecken (16) zündet.

4. Marx-Generator (2) nach einem der vorhergehenden Ansprüche,
**dadurch gekennzeichnet, dass**
wobei die Zweige (4a,b) auch mindestens hinsichtlich wenigstens einer der Kondensatorstufen (10), die der ersten nachfolgen, und auch hinsichtlich der zwischen den gemeinsamen Kondensatorstufen (10) liegenden Querzweige (14) zusammenfallen.

5. Marx-Generator (2) nach einem der vorhergehenden Ansprüche,
**dadurch gekennzeichnet, dass**
mindestens zwei der Zweige (4a,b) so dimensioniert sind, dass beim Betrieb des Marx-Generators (2) die Marx-Spannungen (UM1,2) an deren Ausgangspolen (6a,b) gleichzeitig bereitgestellt werden.

6. Marx-Generator (2) nach einem der vorhergehenden Ansprüche,
**dadurch gekennzeichnet, dass**
mindestens zwei der Zweige (4a,b) eine identische Marx-Struktur aufweisen.

7. Marx-Generator (2) nach einem der vorhergehenden Ansprüche,
**dadurch gekennzeichnet, dass**
die erste Kondensatorstufe (10) hinsichtlich wenigstens einer Ladeleitungen (30a,b) über eine Ladeimpedanz (32) mit dem Eingangspol (22) verbunden ist.

8. Marx-Generator (2) nach einem der vorhergehenden Ansprüche,
**dadurch gekennzeichnet, dass**
der Marx-Generator (2) einen weiteren den Zweigen (4a,b) gemeinsamen Eingangs-Querzweig (34) zwischen dem Eingangspol (22) oder dessen Gegenpol (8) und der ersten Kondensatorstufe (10) enthält.

9. Marx-Generator (2) nach einem der vorhergehenden Ansprüche,
**dadurch gekennzeichnet, dass**
die Kondensatorstufen (10) des Zündabschnittes (24) jeweils für sich eine größere Kapazität als die restlichen Kondensatorstufen (10) für sich aufweisen.

10. Marx-Generator (2) nach einem der vorhergehenden Ansprüche,
**dadurch gekennzeichnet, dass**
die Kondensatorstufen (10) mindestens eines der Zweige (4a,b) räumlich entlang einer Verlaufslinie (58a,b) angeordnet sind, an deren einem Ende sich der jeweilige Ausgangspol (6a,b) und an deren anderem Ende sich dessen Gegenpol (8) befindet, wobei der Abstand zwischen Ausgangspol (6a,b) und Gegenpol (8) kleiner als eine Längsausdehnung des Zweiges (4a,b) entlang der Verlaufslinie (58a,b) ist.

11. Resonatoranordnung (40),
mit einem Marx-Generator (2) nach einem der vorhergehenden Ansprüche und mit wenigstens zwei Resonatoren (42a,b), wobei jeder der Resonatoren (42a,b) an einem jeweiligen Ausgangspol (6a,b) eines der Zweige (4a,b) angeschlossen ist.

12. Strahlungsanordnung (50),
mit einer Resonatoranordnung (40) nach Anspruch 11 und mit einem Multi-Feed-Wellenleiter (52), der wenigstens zwei der Resonatoren (42a,b) zur jeweiligen Einspeisung einer elektromagnetischen Welle (44a,b) enthält.

13. Strahlungsanordnung (50) nach Anspruch 12,
**dadurch gekennzeichnet, dass**
für mindestens zwei der Zweige (4a,b) jeder dieser Zweige (4a,b) einen der Resonatoren (42a,b) zumindest teilweise umgreift und der Zündabschnitt (24) zwischen den Resonatoren (42a,b) verläuft.

14. Strahlungsanordnung (50) nach Anspruch 13,
**dadurch gekennzeichnet, dass**
die Zweige (4a,b) achsensymmetrisch zu einer zwischen den Resonatoren (42a,b) verlaufenden Symmetrieachse (60) angeordnet sind.

## Claims

1. Marx generator (2),
- having at least two branches (4a,b) for delivering a respective Marx voltage (UM1,2) to a respective output terminal (6a,b) of the branch (4a,b),
- each of the branches (4a,b) containing:
- a plurality of capacitor stages (10) connected in series, each having at least a first (12a) and a second voltage pole (12b),
- respective cross branches (14), each two adjacent capacitor stages (10) being connected between the first voltage pole (12a) of the preceding and the second voltage pole (12b) of the succeeding capacitor stage (10) by one of said cross branches (14), each of said cross branches (14) including a spark gap (16),
- a final capacitor stage (10) at its output end (18a,b), one voltage pole (12a,b) of which forms the respective output pole (6a,b) of the branch (4a,b),
- a first capacitor stage (10) at its input end (20), one voltage pole (12a,b) of which is connected to an input pole (22) for supplying an operating voltage (UB),
- wherein at least two of the branches (4a,b) have a common firing section (24) in which they coincide at least with respect to the first capacitor stage (10) and a first adjacent cross branch (14) and the input terminal (22),
- and each of the branches (4a,b) having an ignition portion (24) also has an individual portion (26a,b) containing at least one capacitor stage (10) associated only therewith.

2. Marx generator (2) according to Claim 1,
**characterised in that**
one of the cross branches (14) branches from the ignition portion (24) into the individual portions (26a,b).

3. Marx generator (2) according to either of the preceding claims,
**characterised in that**
the spark gaps (16) of the cross branches (14) and/or the capacitor stages (10) are matched to one another in such a way that, in regular operation of the Marx generator (2), at least one of the spark gaps (16) in the ignition portion (24) ignites before all the other spark gaps (16).

4. Marx generator (2) according to any of the preceding claims,
**characterised in that**
the branches (4a,b) also coinciding at least with respect to at least one of the capacitor stages (10) following the first one and also with respect to the cross branches (14) located between the common capacitor stages (10).

5. Marx generator (2) according to any of the preceding claims,
**characterised in that**
at least two of the branches (4a,b) are dimensioned in such a way that during operation of the Marx generator (2) the Marx voltages (UM1,2) are provided simultaneously at their output poles (6a,b).

6. Marx generator (2) according to any of the preceding claims,
**characterised in that**
at least two of the branches (4a,b) have an identical Marx structure.

7. Marx generator (2) according to any of the preceding claims,
**characterised in that**
the first capacitor stage (10) is connected with respect to at least one charging line (30a,b) via a charging impedance (32) to the input terminal (22).

8. Marx generator (2) according to any of the preceding claims,
**characterised in that**
the Marx generator (2) contains a further input cross branch (34) common to the branches (4a,b) between the input pole (22) or its opposite pole (8) and the first capacitor stage (10).

9. Marx generator (2) according to any of the preceding claims,
**characterised in that**
the capacitor stages (10) of the ignition portion (24) each individually have a greater capacitance than the remaining capacitor stages (10) individually.

10. Marx generator (2) according to any of the preceding claims,
**characterised in that**
the capacitor stages (10) of at least one of the branches (4a,b) are arranged spatially along a line of progression (58a,b), at one end of which the respective output pole (6a,b) is located and at the other end of which its opposite pole (8) is located, the distance between the output pole (6a,b) and the opposite pole (8) being smaller than a longitudinal extent of the branch (4a,b) along the line of progression (58a,b).

11. Resonator arrangement (40),
with a Marx generator (2) according to any of the preceding claims and with at least two resonators (42a,b), each of said resonators (42a,b) being connected to a respective output pole (6a,b) of one of said branches (4a,b).

12. Radiation arrangement (50),
with a resonator arrangement (40) according to Claim 11 and with a multi-feed waveguide (52) comprising at least two of the resonators (42a,b) for respectively feeding an electromagnetic wave (44a,b).

13. Radiation arrangement (50) according to Claim 12, **characterised in that**
for at least two of the branches (4a,b), each of these branches (4a,b) at least partially surrounds one of the resonators (42a,b) and the ignition portion (24) extends between the resonators (42a,b).

14. Radiation arrangement (50) according to Claim 13, **characterised in that**
the branches (4a,b) are arranged axisymmetrically to an axis of symmetry (60) extending between the resonators (42a,b).

## Revendications

1. Générateur de Marx (2),
- comprenant au moins deux branches (4a, b) pour émettre une tension Marx (UM1, 2) au niveau d'un pôle de sortie (6a, b) respectif de la branche (4a, b),
- dans lequel chacune des branches (4a, b) comprend :
- plusieurs étages de condensateur (10) connectés en série et qui présentent respectivement au moins un premier (12a) et un deuxième (12b) pôle de tension,
- des branches transversales (14) respectives, dans lequel respectivement deux étages de condensateur (10) voisins entre le premier pôle de tension (12a) de l'étage de condensateur précédent et le deuxième pôle de tension (12b) de l'étage de condensateur (10) suivant sont reliés par l'une des branches transversales (14), chacune des branches transversales (14) comprenant un éclateur (16),
- un dernier étage de condensateur (10) à son extrémité de sortie (18a, b) dont un pôle de tension (12a, b) constitue le pôle de sortie (6a, b) respectif de la branche (4a, b),
- un premier étage de condensateur (10) à son extrémité d'entrée (20) dont un pôle de tension (12a, b) est relié à un pôle d'entrée (22) pour injecter une tension de fonctionnement (UB),
- dans lequel au moins deux des branches (4a, b) présentent une section d'allumage (24) commune dans laquelle elles coïncident au moins en ce qui concerne le premier étage de condensateur (10) et une première branche transversale (14) voisine et le pôle d'entrée (22),
- et chacune des branches (4a, b) pourvue de la section d'allumage (24) comprend aussi une section individuelle (26a, b) qui comprend au moins un étage de condensateur (10) associé uniquement à ladite section.

2. Générateur de Marx (2) selon la revendication 1, **caractérisé en ce que** l'une des branches transversales (14) se ramifie à partir de la section d'allumage (24) en sections individuelles (26a, b).

3. Générateur de Marx (2) selon l'une quelconque des revendications précédentes, **caractérisé en ce que** les éclateurs (16) des branches transversales (14) et/ou les étages de condensateur (10) sont adaptés les uns aux autres de telle sorte qu'en fonctionnement normal du générateur de Marx (2) au moins l'un des éclateurs (16) dans la section d'allumage (24) est amorcé avant tous les autres éclateurs (16).

4. Générateur de Marx (2) selon l'une quelconque des revendications précédentes, **caractérisé en ce que** les branches (4a, b) coïncident aussi au moins en ce qui concerne au moins l'un des étages de condensateur (10) qui suivent le premier, et aussi en ce qui concerne les branches transversales (14) situées entre les étages de condensateur (10) communs.

5. Générateur de Marx (2) selon l'une quelconque des revendications précédentes, **caractérisé en ce qu'**au moins deux des branches (4a, b) sont dimensionnées de telle sorte que lors du fonctionnement du générateur de Marx (2) les tensions Marx (UM1, 2) sont fournies en même temps au niveau de leurs pôles de sortie (6a, b).

6. Générateur de Marx (2) selon l'une quelconque des revendications précédentes, **caractérisé en ce qu'**au moins deux des branches (4a, b) présentent une structure de Marx identique.

7. Générateur de Marx (2) selon l'une quelconque des revendications précédentes, **caractérisé en ce que** le premier étage de condensateur (10) est relié au pôle d'entrée (22) en ce qui concerne au moins l'une des lignes de charge (30a, b) par une impédance de charge (32) .

8. Générateur de Marx (2) selon l'une quelconque des revendications précédentes, **caractérisé en ce que** le générateur de Marx (2) comprend une branche transversale d'entrée (34) supplémentaire, commune aux branches (4a, b), entre le pôle d'entrée (22) ou son pôle opposé (8) et le premier étage de condensateur (10) .

9. Générateur de Marx (2) selon l'une quelconque des revendications précédentes, **caractérisé en ce que** les étages de condensateur (10) de la section d'allumage (24) présentent respectivement chacun une capacité supérieure à chacun des étages de condensateur (10) restants.

10. Générateur de Marx (2) selon l'une quelconque des revendications précédentes, **caractérisé en ce que** les étages de condensateur (10) d'au moins l'une des branches (4a, b) sont disposés dans l'espace le long d'un tracé (58a, b) à une extrémité duquel se trouve le pôle de sortie (6a, b) respectif et à l'autre extrémité duquel se trouve son pôle opposé (8), dans lequel la distance entre le pôle de sortie (6a, b) et le pôle opposé (8) est inférieure à une étendue longitudinale de la branche (4a, b) de long du tracé (58a, b).

11. Agencement de résonateur (40), comprenant un générateur de Marx (2) selon l'une quelconque des revendications précédentes et au moins deux résonateurs (42a, b), chacun des résonateurs (42a, b) étant connecté à un pôle de sortie (6a, b) respectif d'une des branches (4a, b).

12. Agencement de rayonnement (50), comprenant un agencement de résonateur (40) selon la revendication 11 et un guide d'ondes à sources multiples (52) qui comprend au moins deux des résonateurs (42a, b) pour l'injection respective d'une onde électromagnétique (44a, b).

13. Agencement de rayonnement (50) selon la revendication 12, **caractérisé en ce que** pour au moins deux des branches (4a, b) chacune de ces branches (4a, b) entoure au moins partiellement l'un des résonateurs (42a, b) et la section d'allumage (24) s'étend entre les résonateurs (42a, b).

14. Agencement de rayonnement (50) selon la revendication 13, **caractérisé en ce que** les branches (4a, b) sont disposées de manière symétrique à l'axe par rapport à un axe de symétrie (60) s'étendant entre les résonateurs (42a, b).
